# EUROPÄISCHE PATENTSCHRIFT

(11) **EP 1 581 992 B1**
(45) Veröffentlichungstag und Bekanntmachung des Hinweises auf die Patenterteilung: **23.05.2007**
(21) Anmeldenummer: 03785793.5
(22) Anmeldetag: 11.12.2003
(51) Int. Cl.: H02N 2/16

(54) **Verfahren zum Betreiben eines piezoelektrischen Motors sowie piezoelektrischer Motor mit einem Stator in Form eines hohlzylindrischen Oszillators**
Method for operating a piezoelectric motor, and piezoelectric motor comprising a stator in the form of a hollow cylindrical oscillator
Procédé pour faire fonctionner un moteur piézoélectrique et moteur piézoélectrique comprenant un stator qui se présente sous la forme d'un oscillateur cylindrique creux

(30) Priorität: 08.01.2003 DE 10300266; 01.04.2003 DE 10314810
(43) Veröffentlichungstag der Anmeldung: 05.10.2005
(73) Patentinhaber: Physik Instrumente (PI) GmbH & Co. KG, 76228 Karlsruhe (DE)
(72) Erfinder: VYSHNEVSKYY, Oleksiy, 76744 Woerth (DE); WISCHNEWSKIY, Wladimir, 76337 Waldbronn (DE)
(74) Vertreter: Kruspig, Volkmar
(86) Internationale Anmeldenummer: PCT/EP2003/014077
(87) Internationale Veröffentlichungsnummer: WO 2004/064170

(56) Entgegenhaltungen:
- EP-A- 0 793 282
- EP-A- 1 061 638
- DE-C- 19 522 072
- PATENT ABSTRACTS OF JAPAN Bd. 015, Nr. 179 (E-1064), 8. Mai 1991 (1991-05-08) -& JP 03 040765 A (TOKIN CORP; others: 01), 21. Februar 1991 (1991-02-21)
- PATENT ABSTRACTS OF JAPAN Bd. 012, Nr. 435 (E-683), 16. November 1988 (1988-11-16) -& JP 63 167683 A (MURATA MFG CO LTD), 11. Juli 1988 (1988-07-11)

## Beschreibung

Die Erfindung betrifft ein Verfahren zum Betreiben eines piezoelektrischen Motors mit einem Stator in Form eines hohlzylindrischen Oszillators, dessen mindestens eine Stirnseite mit einem Rotor in Friktionskontakt steht sowie Stehwellengeneratoren gemäß Oberbegriff des Patentanspruchs 1, einen piezoelektrischen Motor mit einem Stator in Form eines hohlzylindrischen Oszillators, dessen mindestens eine Stirnseite mit einem Rotor in Friktionskontakt steht und welcher Stehwellengeneratoren gemäß Oberbegriff des Patentanspruchs 3 aufweist.

Aus der US-PS 5,654,604 sind piezoelektrische Ultraschallmotoren bekannt, deren Funktionsweise auf der Anregung dünner metallischer Resonatoren beruht, in denen Biegewellen erzeugt werden.

Zur Anregung von Biegewellen wird bei derartigen Motoren an einen metallischen Resonator eine dünne piezoelektrische Scheibe, bevorzugt durch Kleben befestigt. Ein wesentlicher Nachteil dieser Motoren besteht darin, dass aufgrund unterschiedlicher thermischer Ausdehnungskoeffizienten der piezoelektrischen Scheibe einerseits und des metallischen Resonators andererseits es quasi unmöglich ist, eine starre Verbindung zu erreichen. Aufgrund dessen wird eine solche Verbindung mittels eine gewisse Restelastizität aufweisender Epoxidklebstoffe durchgeführt, um die Unterschiede in den Ausdehnungskoeffizienten zu kompensieren. Eine solche Verbindung verschlechtert jedoch die akustische Kopplung zwischen dem metallischen Resonator und der piezoelektrischen Scheibe, wodurch die Oszillatorleistung begrenzt ist und die mechanischen Verluste des Motors steigen. Aufgrund des Einflusses der Ultraschallenergie auf den Klebstoff besteht die Gefahr, dass dieser sich in seiner Viskosität verändert, mit der Folge, dass sich die Schwingungseigenschaften des Motors verschlechtern. Aus den vorstehend genannten Gründen haben derartig ausgebildete Motoren nur eine begrenzte mechanische Leistung, eine geringe Betriebsdauer und damit insgesamt unbefriedigende praktische Eigenschaften.

Bekannt sind auch piezoelektrische Ultraschallmotoren, deren Funktionsweise auf der Anregung in einem monolithischen, zylinderförmigen piezoelektrischen Resonator laufender Dehnungswellen beruht. Verwiesen sei hier beispielsweise auf die US-PS 5,872,418.
Da bei solchen Motoren der gesamte Resonator aus einem piezoelektrischen Material ausgeführt ist, treten Probleme aufgrund unterschiedlicher Ausdehnungskoeffizienten nicht auf. Nachteilig bei den Dehnungswellen nutzenden Ultraschallmotoren ist jedoch die Tatsache, dass alle Punkte des Oszillators annähernd die gleiche Schwinggeschwindigkeit besitzen. Dies bedeutet eine gleichmäßige Verteilung der im Oszillator gespeicherten Energie über das gesamte Volumen, wodurch es zu unnötigen Verlusten aufgrund innerer Reibung der Punkte kommt, die nicht in unmittelbarer Nähe der Oszillator-Friktionsflächen liegen. Außerdem existieren auf der Oszillatoroberfläche derartiger Motoren keine Bereiche, auf denen die Schwinggeschwindigkeit Nullwerte annimmt. Dies bedeutet, dass es schwierig ist, den Oszillator eines solchen Motors gegenüber einem Gehäuse starr zu befestigen. Deshalb wird eine Befestigung über gummiartige, elastische Materialien vorgenommen, die sich aber aufgrund des Ultraschalleinflusses erwärmen. Selbiges führt zu Energieverlusten und zur Erwärmung des gesamten Motors.
Die Berührung der elastischen Fixierung mit dem schwingenden Oszillator verringert außerdem die mechanische Güte, wodurch eine höhere Anregungsspannung notwendig wird. Die erforderliche elastische Nachgiebigkeit der Befestigungsanordnung verhindert die absolut starre Fixierung des Stators gegenüber einem Gehäuse und verkompliziert die Phasencharakteristiken solcher Motoren, wodurch ihr Einsatz in Systemen zum Zweck der Fein- und Mikropositionierung schwieriger und kostenintensiver wird.

Aus der DE 195 22 072 C1 ist ein Verfahren zum Betreiben eines piezoelektrischen Motors gemäß dem Oberbegriff des Anspruchs 1 bekannt.

Die JP 03 040 765 A beschreibt einen piezoelektrischen Motor mit einem hohlzylindrischen oszillator, der auf der Mitte der Zylinderhöhe befestigt ist.

Aus dem Vorstehenden ist es daher Aufgabe der Erfindung, ein weiterentwickeltes Verfahren zum Betreiben eines piezoelektrischen Motors mit einem Stator in Form eines hohlzylindrischen Oszillators anzugeben, dessen mindestens eine Stirnseite mit einem Rotor in Friktionskontakt steht. Weiterhin ist es Aufgabe der Erfindung, einen piezoelektrischen Motor mit einem Stator in Form eines hohlzylindrischen Oszillators zu schaffen, wobei die Energieverluste sowohl im Oszillator als auch in der Befestigungsvorrichtung des Oszillators bzw. des Motors gering gehalten werden sollen. Aufgabengemäß ist die Erregerspannung für derartige Motoren zu senken und für eine verbesserte Phasencharakteristik Sorge zu tragen.

Die Lösung der Aufgabe der Erfindung erfolgt verfahrensseitig mit der Lehre nach Patentanspruch 1 sowie bezogen auf den piezoelektrischen Motor mit der Merkmalskombination nach Patentanspruch 3, wobei die Unteransprüche mindestens zweckmäßige Ausgestaltungen und Weiterbildungen umfassen.

Demnach liegt der Grundgedanke der Erfindung darin, den hohlzylindrischen Oszillator mit einem neuen Typ einer akustischen Welle anzuregen, indem dieser in einen gekoppelten, tangential-axialen Schwingungsmode versetzt wird. Die Oszillatorabmessungen sind so gewählt und die Anregungsvorrichtung ist derartig ausgestaltet, dass eine solche Verteilung der Schwinggeschwindigkeiten der akustischen Welle auf dem Umfang des Oszillators und entlang seiner Höhe erreicht wird, bei der die im Oszillator zirkulierende Schwingungsenergie sich an den im Friktionskontakt mit dem Rotor stehenden Stirnflächen des Oszillators konzentriert und in der Mitte der Oszillatorlänge bzw. Oszillatorhöhe eine Knotenlinie minimaler Schwinggeschwindigkeiten verläuft. An dieser Knotenlinie mit minimalen Schwinggeschwindigkeiten kann dann eine starre Befestigung, z. B. zu einem Motorgehäuse vorgenommen werden.

Es besteht also der zu schaffende piezoelektrische Ultraschallmotor aus einem hohlzylindrischen Oszillator mit mindestens einer in Friktionskontakt mit einem Rotor stehenden Stirnseite. Außerdem enthält der Oszillator Generatoren akustischer Stehwellen, wobei jeder von diesen Generatoren ein Generator solcher akustischer Stehwellen ist, die eine gekoppelte, tangential-axiale Schwingung des Oszillatorkörpers darstellen, wobei die tangentiale und die axiale Schwingkomponente eine Phasenlage von 0 oder 180° besitzen, die tangentialen Schwinggeschwindigkeits-Maxima sich an den Oszillatorstirnseiten befinden und die axialen Schwinggeschwindigkeits-Maxima etwas unterhalb dieser Oszillatorstirnseiten verlaufen. Mit zunehmender Entfernung von den Oszillatorstirnseiten in axialer Richtung werden die beiden Schwinggeschwindigkeiten immer kleiner, wobei in der Mitte der Höhe des hohlzylindrischen Oszillatorkörpers und parallel zu den Oszillatorstirnseiten eine Knotenlinie verläuft, auf der die axialen Schwinggeschwindigkeiten den Wert Null annehmen und die tangentialen Schwinggeschwindigkeiten ein Minimum erreichen.
Weiterhin wird der Oszillatorkörper abwechselnd durch axial verlaufende Knotenlinien geteilt, in denen jeweils die tangentialen oder die axialen Schwinggeschwindigkeitswerte Null erreichen.

Mit anderen Worten wird der Hohlzylinder des piezoelektrischen Motors in eine gekoppelte tangential-axiale Schwingungsmode versetzt, wobei der Zylinder überwiegend tangentiale und axiale Schwingungskomponenten aufweist. Die Anregung des Oszillators erfolgt derart, dass sich die Schwinggeschwindigkeits-Maxima der tangentialen Komponenten an den Stirnseiten des Hohlzylinders und diejenigen der axialen Komponenten darunter ausbilden, wobei, wie vorerwähnt, zur Mitte der Zylinderhöhe die Komponenten abnehmen und in der Mitte der Zylinderhöhe im wesentlichen parallel zu den Stirnseiten eine Knotenlinie entsteht, auf der die axiale Schwingungskomponente den Wert Null sowie die tangentialen Komponenten ein Minimum annehmen.

Die Anregung erfolgt mit einer Frequenz, die der Oszillatorresonanzfrequenz entspricht und bei der sich eine stehende Welle der gekoppelten tangential-axialen Schwingungsmode ausbildet.

Da im Oszillator des erfindungsgemäßen Motors eine solche akustische Welle angeregt wird, deren Schwinggeschwindigkeits-Maxima sich an den mit dem Rotor in Friktionskontakt stehenden Oszillatorstirnseiten befinden und die Schwinggeschwindigkeits-Minima im mittleren Oszillatorteil verlaufen, konzentriert sich die kinetische Energie des Oszillators in der Nähe der Oszillatorstirnseiten, also dort, wo sie zum Antreiben des Rotors benötigt wird.

Durch die vorstehend beschriebenen Maßnahmen werden die Verluste auf ein vertretbares Maß der inneren Reibung verringert. Hierdurch reduziert sich auch die unerwünschte Erwärmung des hohlzylindrischen Oszillatorkörpers.

Weiterhin wird es möglich, wie bereits angedeutet, im mittleren Teil des Oszillators eine Befestigungsvorrichtung anzuordnen, die den Oszillator, d.h. den hohlzylindrischen Körper nicht belastet. Ein zu höheren Energieverlusten führender mechanischer Widerstand durch diese Befestigungsvorrichtung liegt nicht vor. Dadurch kann die zur Anregung des Oszillators notwendige elektrische Spannung reduziert werden.

Der piezoelektrische Motor nach der Erfindung kann in verschiedenen Ausführungsformen realisiert werden.

Bei einer ersten Ausführungsform ist der Oszillator, d.h. der hohlzylindrische Körper als monolithischer piezoelektrischer Körper ausgebildet, auf dessen Mantelfläche sich eine oder mehre Elektroden befinden.

Zusammen mit der, z. B. auf der Mantelinnenfläche liegenden gemeinsamen Bezugselektrode und der dazwischen befindlichen Piezokeramik wird ein Generator akustischer Stehwellen gebildet.

Eine solche erste Ausführungsform des erfindungsgemäßen Motors ermöglicht minimale Abmessungen.

Bei einer zweiten Ausführungsform kann der Oszillator als ein monolithischer, nicht piezoelektrischer Körper ausgebildet werden. Die Generatoren akustischer Stehwellen sind bei dieser Ausführungsform als starre mit dem Oszillator verbundene Piezoelemente ausgestaltet.

Bei einer derartigen Variante können Motoren größerer Abmessungen und größerer Leistungen realisiert werden.

Eine weitere vorteilhafte Ausführungsform des erfindungsgemäßen Motors besteht darin, dass der Oszillator zwei, räumlich um ein Viertel der Wellenlänge verschobene Stehwellengeneratoren enthält.
Die elektrische Anregung der Generatoren erfolgt dann zweiphasig mit einer Phasenverschiebung von 90°. Bei dieser Anregungsform wird im Oszillator eine laufende Welle erzeugt und der Rotor bekommt eine, der laufenden Welle entgegengesetzte Bewegungsrichtung. Bei einer solchen Konstruktion besteht die Möglichkeit, zweiphasige Wanderwellenmotoren zu schaffen.

Ebenso ist es möglich, den erfindungsgemäßen Piezomotor so aufzubauen, dass der oszillator drei, räumlich um ein Drittel der Wellenlänge verschobene Stehwellengeneratoren enthält.
Die elektrische Anregung der Generatoren wird dann dreiphasig mit einer Phasenverschiebung von 120° gewählt. Auch auf diesem Wege wird im Oszillator eine laufende Welle erzeugt und es bekommt der Rotor eine, der laufenden Welle entgegengesetzte Bewegungs- bzw. Drehrichtung. Diese Variante schafft die Möglichkeit der Realisierung von dreiphasigen Wanderwellenmotoren.

Letztendlich besteht die Möglichkeit, den erfindungsgemäßen Motor so zu gestalten, dass der Oszillator mindestens eine Gruppe gleichnamiger Generatoren akustischer Stehwellen enthält. Die Generatoren sind gegeneinander räumlich um eine halbe Wellenlänge verschoben und an die elektrische Erregerquelle angeschlossen.

Die Oszillatorhöhe ist bei dieser Ausführungsform so gewählt, dass gleichzeitig mit der tangential-axialen Oszillatorschwingung auch longitudinale Schwingungen des Oszillators auftreten. Die Überlagerung beider Schwingungsformen veranlasst die Punkte, die an den Stirnseiten des Oszillators liegen, zum Ausführen geradliniger, unter einem Winkel zur Oberfläche geneigter Bewegungen. Hierdurch kann in einfacher Weise ein piezoelektrischer Stehwellenmotor geschaffen werden.

Die Erfindung soll nachstehend anhand von Ausführungsbeispielen sowie unter Zuhilfenahme von Figuren näher erläutert werden.

Hierbei zeigen:
- Fig. 1: eine Explosivdarstellung einer Ausführungsform eines erfindungsgemäßen Piezomotors mit hohlzylindrischem Oszillator;
- Fig. 2: eine Oszillatoranordnung zur Anregung einer ersten Schwingungsmode;
- Fig. 3: Darstellungen der ersten Schwingungsmode;
- Fig. 4: eine Oszillatoranordnung zur Anregung der zweiten Schwingungsmode;
- Fig. 5: Darstellungen des Verlaufs der zweiten Schwingungsmode;
- Fig. 6: eine Oszillatoranordnung zur Anregung der dritten Schwingungsmode;
- Fig. 7: Darstellungen der Ausbildung der dritten Schwingungsmode;
- Fig. 8: eine Detaildarstellung des Oszillators aus einem nicht piezoelektrischen Körper mit darauf angeordneten Piezoaktoren;
- Fig. 9: einen Verlauf der Bewegungsbahnen von an den Oszillatorstirnseiten liegenden Punkten bei Anregung einer Stehwelle;
- Fig. 10: eine Oszillatorausbildung für einen Zweiphasenmotor;
- Fig. 11: eine beispielhafte elektrische Beschaltung für einen Zweiphasenmotor;
- Fig. 12: eine Ausführungsform eines Oszillators für einen Dreiphasenmotor;
- Fig. 13: eine beispielhafte elektrische Beschaltung für einen Dreiphasenmotor;
- Fig. 14: Bewegungsbahnen der an den Oszillatorstirnseiten befindlichen Punkte bei Anregung einer Wanderwelle;
- Fig. 15: (a) Verlauf tangentialer sowie axialer Schwinggeschwindigkeiten auf der Stirnseite des Oszillators; (b) Phasenlage zwischen tangentialen sowie axialen Schwingauslenkungen; (c) Bewegungsbahnen der an den Oszillatorstirnseiten liegenden Punkte bei gleichzeitiger Anregung tangential-axialer Schwingungen und longitudinaler Schwingungen;
- Fig. 16: eine Ausführungsform eines Oszillators für einen Einphasenmotor sowie
- Fig. 17: eine beispielhafte elektrische Beschaltung für einen Einphasenmotor.

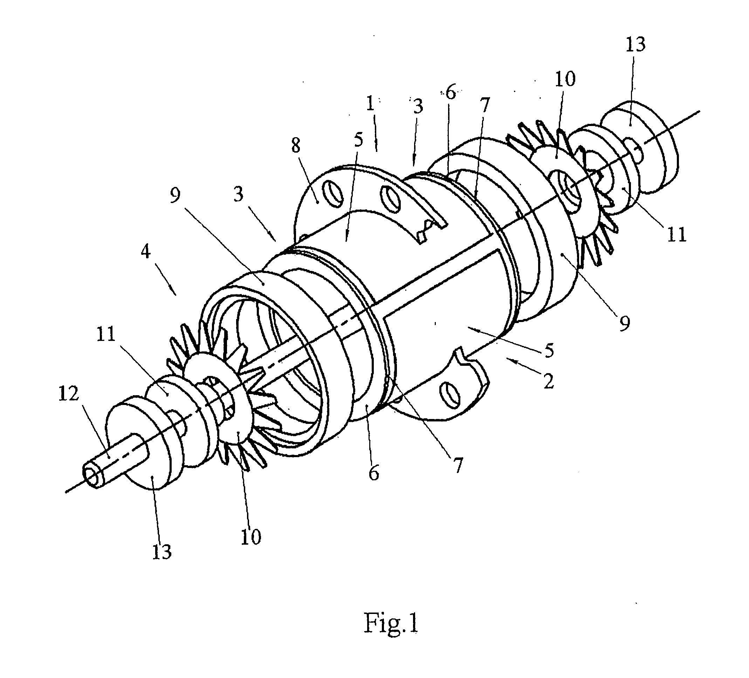

Der in der Fig. 1 gezeigte piezoelektrische Ultraschallmotor umfasst einen mit mindestens einer seiner Friktionsseite 3 in Friktionskontakt mit dem Rotor 4 stehenden Stator 1.

Der Oszillator 2 umfasst Stehwellengeneratoren 5 sowie die auf die Oszillatorstirnseiten 7 aufgebrachten jeweiligen Friktionsschichten 6.

Die Befestigung des Oszillators 2 gegenüber einem nicht gezeigten Motorgehäuse wird mit Hilfe einer Halterung 8 realisiert.

Der Rotor 4 enthält Friktionsscheiben 9, die mit Hilfe elastischer Elemente 10 an den Oszillator 2 angepresst werden. Diese elastischen Elemente 10 können beispielsweise metallische Federelemente oder Kunststoff-Federn, die nach Art einer Tellerfeder ausgebildet sind, sein.

Der Rotor 4 enthält außerdem die an der Welle 12 angeordneten Zentrierbuchsen 11 sowie Lager 13.

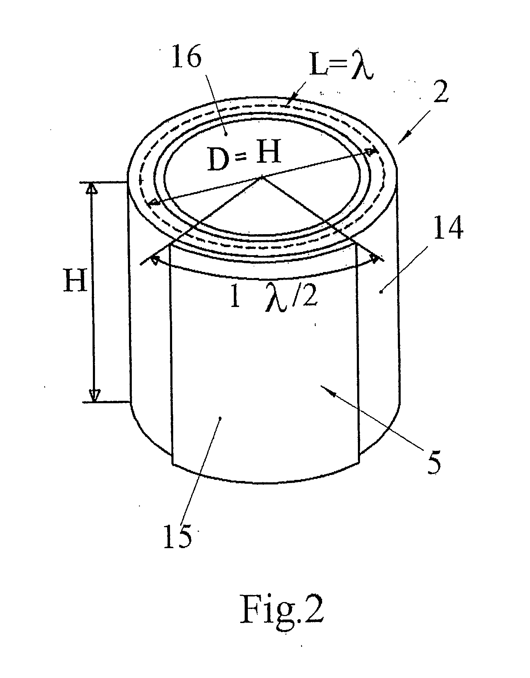

Fig. 2 zeigt einen als monolithischen, piezoelektrischen, radial polarisierten Hohlzylinderkörper 14 ausgeführten Oszillator 2 des erfindungsgemäßen Motors, bei dem der Durchmesser D seiner Umfangsmittellinie L ungefähr gleich der Höhe H und die Umfangsmittellinie L gleich der auf dem Oszillatorumfang angeregten Wellenlänge λ ist.

Aus Verständlichkeitsgründen und zum leichteren Illustrieren der Anregungsweise sowie der Wellenform ist dieser Oszillator nur mit einem Generator 5 ausgestattet. Der Generator 5 wird durch die Anregungselektrode 15, die auf der äußeren Mantelfläche liegt, die gemeinsame Bezugselektrode 16, die auf der inneren Mantelfläche liegt, sowie dem Bereich der dazwischen liegenden polarisierten Piezokeramik gebildet. Die Länge der Anregungselektrode 15 ist gewöhnlich gleich oder kleiner als die halbe Wellenlänge λ.

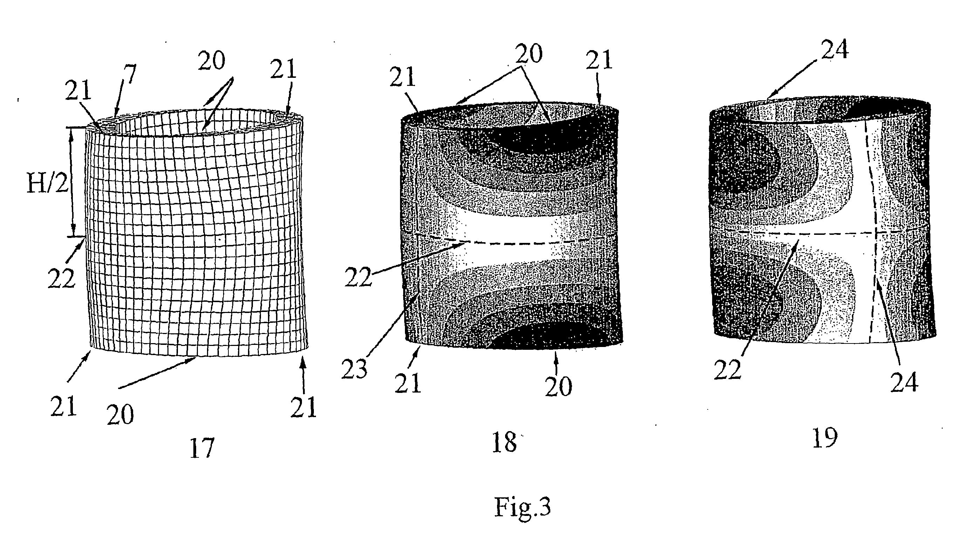

Mit Hilfe der Fig. 3, Position 17, sei das Verformungsbild des Oszillators beim Anregen nur einer Stehwelle der gekoppelten tangential-axialen Schwingungen mit Hilfe nur eines Generators 5 illustriert.

Die Umfangsmittellinie L entspricht der Wellenlänge λ der im Oszillator angeregten Welle, d.h. im Oszillator wird die erste gekoppelte tangential-axiale Schwingungsmode angeregt.

Die Positionen 18 und 19 zeigen die Verteilung der tangentialen und axialen Schwinggeschwindigkeiten für diesen in Position 17 gezeigten Fall.

Beim Anregen des Oszillators 2 der ersten gekoppelten tangential-axialen Schwingungsmode bilden sich an den Oszillatorstirnseiten 7 abwechselnd die Maxima 20 und die Minima 21 der tangentialen Schwinggeschwindigkeiten aus. Außerdem entsteht an den Mantelflächen des Oszillators eine Knotenlinie 22, die sich annähernd in der Mitte der Oszillatorhöhe befindet und parallel zu den Stirnoberflächen verläuft. Auf dieser Knotenlinie nehmen die tangentialen Schwinggeschwindigkeiten ihren minimalen und die axialen Schwinggeschwindigkeiten den Nullwert an.

Die Mantelflächen des Oszillators 2 werden außerdem abwechselnd durch vier axial verlaufende Knotenlinien 23, 24 geteilt, auf denen die tangentialen und axialen Schwinggeschwindigkeiten ihren Nullwert annehmen.

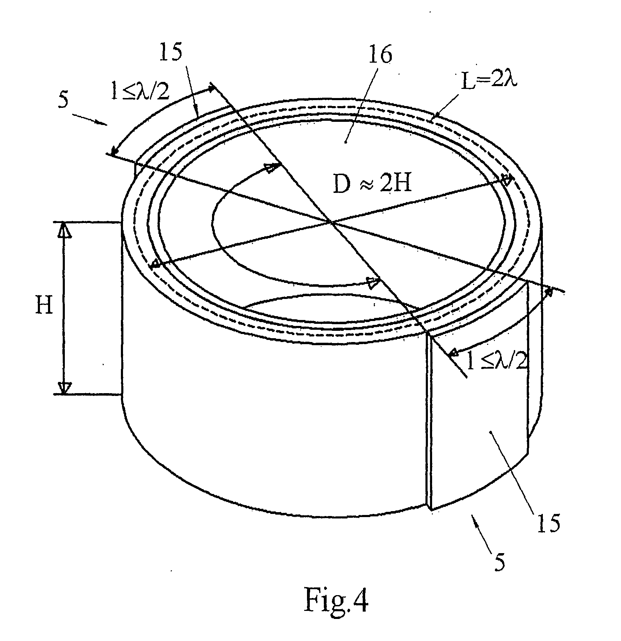

Die Fig. 4 stellt einen Oszillator 2 des vorgeschlagenen Motors dar, bei dem der Durchmesser D seiner Umfangsmittellinie L ungefähr gleich 2H ist und wobei die Umfangsmittellinie L den Wert 2λ einnimmt. Dieser Oszillator ist mit zwei Stehwellengeneratoren 5 ausgestattet.

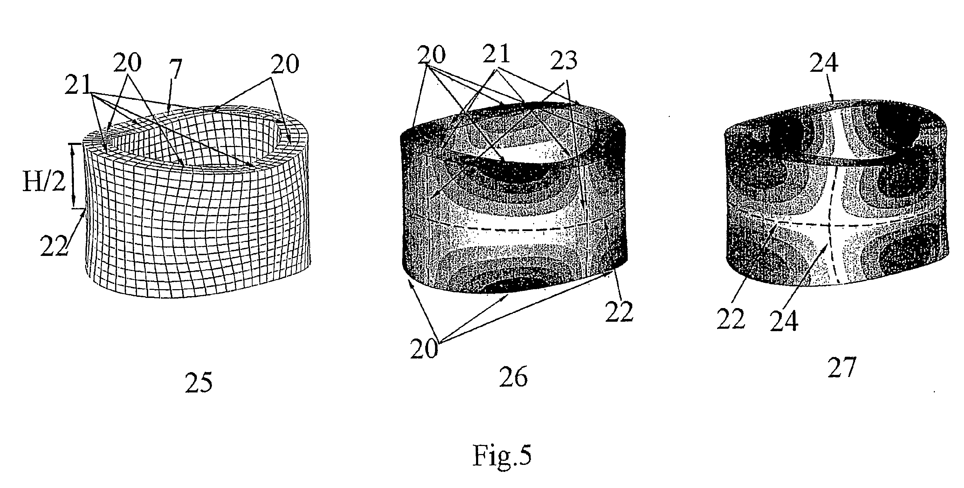

Fig. 5, Position 25 zeigt nun das Verformungsbild des Oszillators 2 gemäß Fig. 4 beim Anregen nur einer Stehwelle der gekoppelten tangential-axialen Schwingungen mit Hilfe von zwei Generatoren 5.

Die Umfangsmittellinie L ist hier gleich 2λ, d.h. im Oszillator wird die zweite gekoppelte tangential-axiale Schwingungsmode angeregt.
Die Positionen 26 und 27 zeigen die Verteilung der tangentialen und axialen Schwinggeschwindigkeiten für diesen Fall.

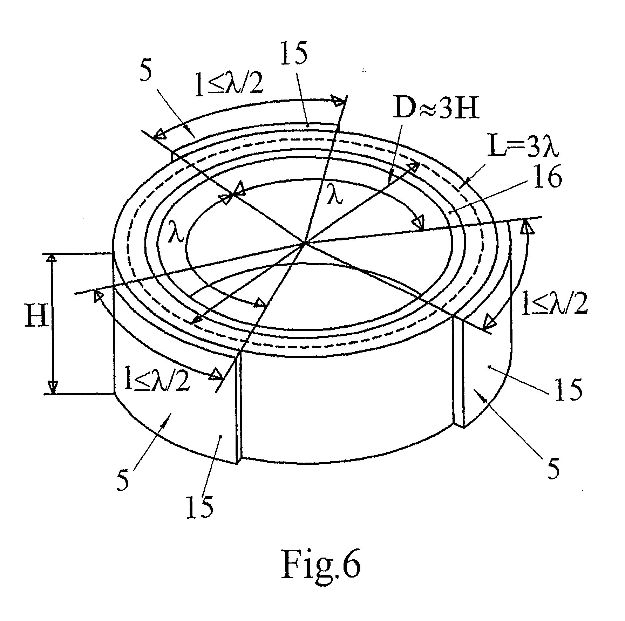

Fig. 6 betrifft einen Oszillator 2 des erfindungsgemäßen Motors, bei dem der Durchmesser D seiner Umfangsmittellinie L ungefähr gleich 3H ist und wobei die Umfangsmittellinie L den Wert 3λ einnimmt. Dieser Oszillator weist drei Stehwellengeneratoren 5 auf.

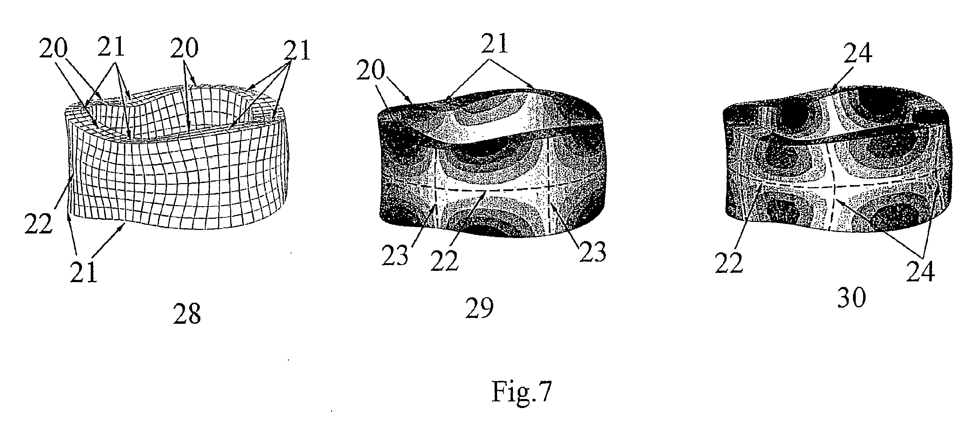

Fig. 7, Position 28 demonstriert nun das Verformungsbild des Oszillators nach Fig. 6 beim Anregen mit nur einer Stehwelle der gekoppelten tangential-axialen Schwingungen mit Hilfe von drei Generatoren 5. Die Umfangsmittellinie L ist hier gleich 3λ, d.h. im Oszillator wird die dritte gekoppelte tangential-axiale Schwingungsmode angeregt.

Die Positionen 29 und 30 zeigen die Verteilung der tangentialen und axialen Schwinggeschwindigkeiten für diesen Fall. Nach dem gleichen Prinzip können mittels der Oszillatoren auch höhere Moden angeregt werden.

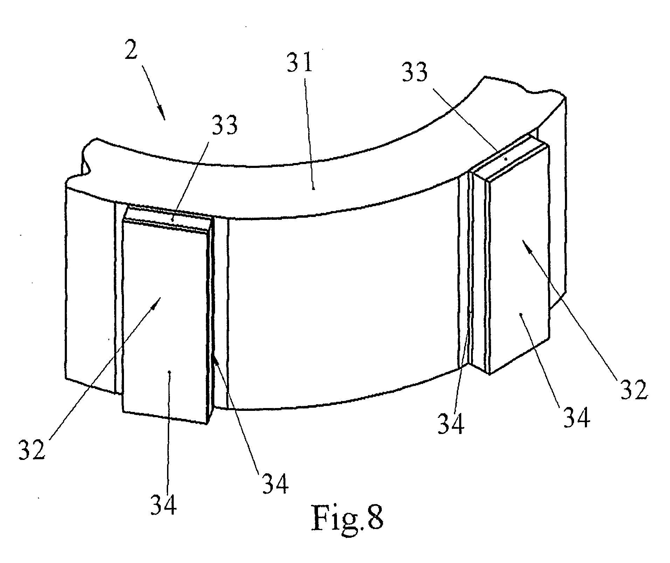

Gemäß der Darstellung nach Fig. 8 ist der Oszillator 2 als ein nicht piezoelektrischer Körper 31 ausgeführt, der z.B. aus Metall, Keramik, Glas oder einem ähnlichen Werkstoff besteht. Dieser Körper 31 weist mit ihm starr verbundene Piezoelemente 32 auf. Die Piezoelemente 32 können in Form piezoelektrischer Platten 33 mit Elektroden 34 ausgeführt werden oder eine andere Form aufweisen.

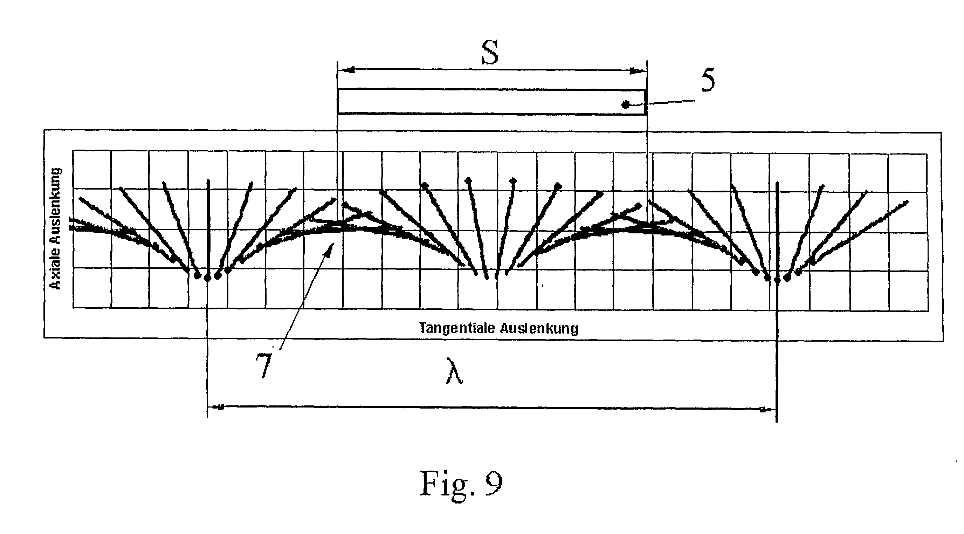

Fig. 9 dient der Erläuterung der Bewegungsbahnen von Punkten an den Oszillatorstirnseiten 7, bei Anregung der gekoppelten tangential-axialen Schwingungsmode. Das Maß S bestimmt dabei den Anordnungsbereich des Generators 5.

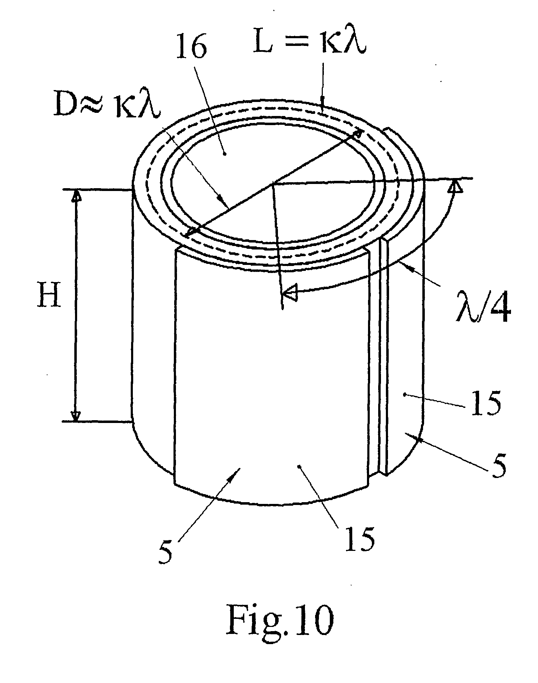

Fig. 10 offenbart eine Variante des Oszillators 2 eines zweiphasigen Wanderwellenmotors unter Ausnutzung der gekoppelten tangential-axialen Schwingungsmode. Dieser Oszillator weist mindestens zwei Generatoren 5 auf, die gegeneinander räumlich um λ/4 der angeregten Wellenlänge versetzt sind.

Zum Betreiben eines solchen Motors erfolgt die elektrische Anregung der Generatoren 5 mit einer Phasenverschiebung von 90°, wodurch im Oszillator 2 eine laufende Welle der gekoppelten tangential-axialen Schwingungen erzeugt wird. Bei entsprechend geänderten konstruktiven Varianten des Motors kann der Oszillator 2 mit mehreren Generatorpaaren 5 ausgestattet werden, die gegeneinander um λ/4 versetzt und parallel verschalten sind. Hierbei ist die Länge der Umfangsmittellinie L ein ganzes Vielfaches von λ, d.h. L = kλ mit k = Anzahl der Generatorpaare 5.

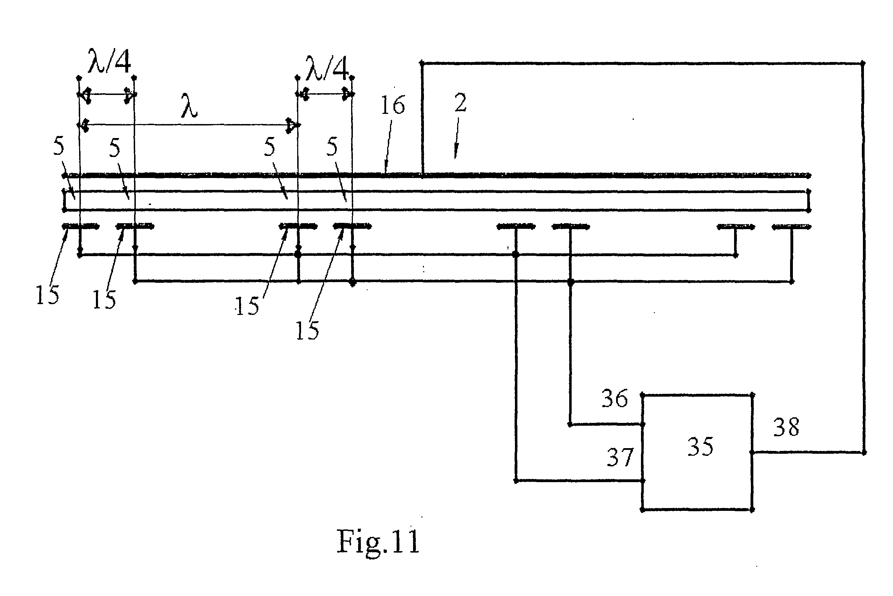

Die Beschaltung eines zweiphasigen Oszillators 2 mit einer zweiphasigen Anregungsquelle 35 zeigt die Fig. 11. Die Quelle 35 weist zwei Ausgänge 36 und 37 auf, die mit der anzuregenden Elektrode 15 des Generators 5 verbunden sind. Weiterhin besitzt die Quelle 35 einen gemeinsamen Ausgang 38, der mit der gemeinsamen Bezugselektrode 16 verbunden ist. Die Quelle 35 stellt zwei um 90° phasenverschobene elektrische Spannungen bereit.

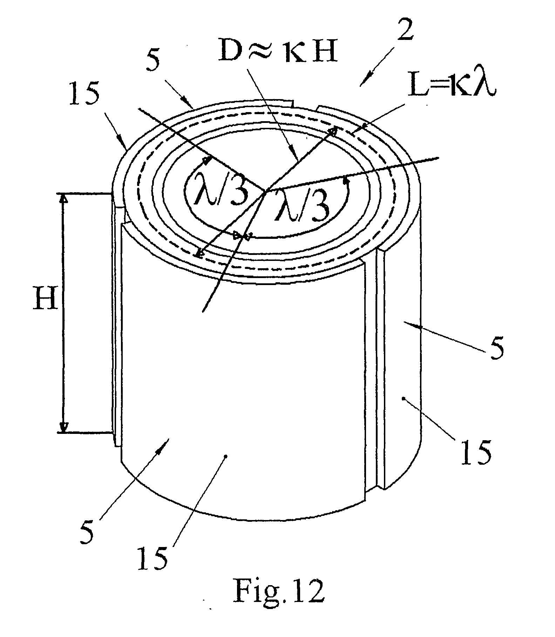

Fig. 12 stellt eine Variante eines Oszillators 2 eines dreiphasigen Wanderwellenmotors unter Ausnutzung .der gekoppelten tangential-axialen Schwingungsmode dar.

Dieser Oszillator ist mit mindestens drei Generatoren 5 ausgestattet, die gegeneinander räumlich um λ/3 der angeregten Wellenlänge versetzt sind. Die elektrische Anregung der Generatoren 5 weist eine Phasenverschiebung von 120° auf, wodurch im Oszillator 2 eine laufende Welle erzeugt wird. Bei unterschiedlichen Konstruktionsvarianten des Motors kann der Oszillator 2 mit mehreren Generatorpaaren 5 ausgestattet werden, die jeweils gegeneinander um λ/3 versetzt und parallel geschaltet sind.

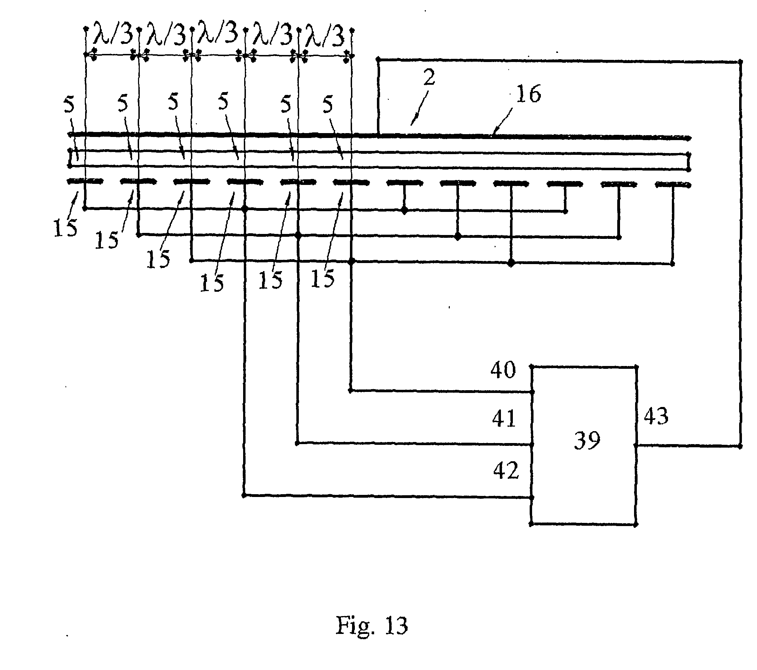

Die Schaltungsanordnung nach Fig. 13 dient der Ansteuerung eines dreiphasigen Oszillators 2 mit einer dreiphasigen Anregungsquelle 39.
Die Quelle 39 weist drei Ausgänge 40, 41 und 42 auf, die mit der Anregungselektrode 15 des Generators 5 verbunden sind, und besitzt außerdem einen gemeinsamen Ausgang 43, der mit der Bezugselektrode 16 in Kontakt steht. Die Erregerquelle stellt drei um 120° phasenverschobene elektrische Spannungen bereit.

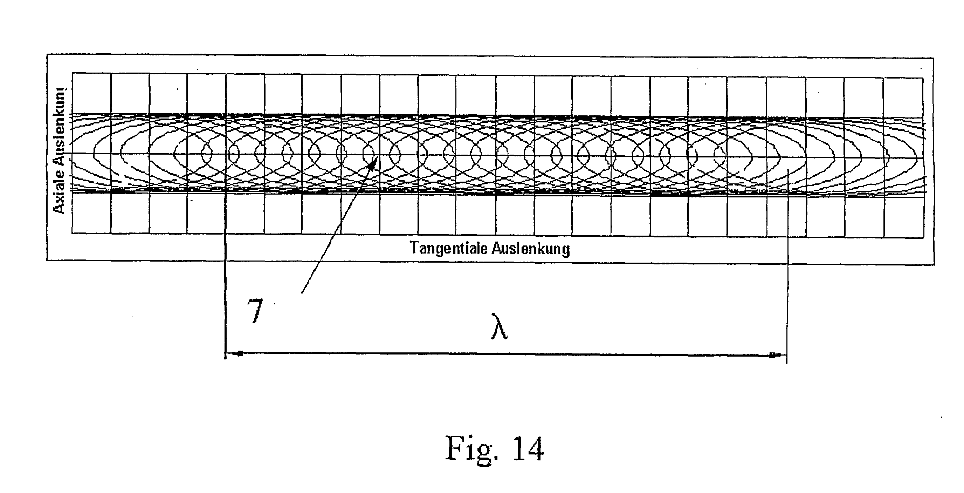

Elliptische Bewegungsbahnen der Oszillatoroberfläche 7 bei der Anregung einer laufenden Welle der gekoppelten tangential-axialen Schwingungen zeigt Fig. 14.

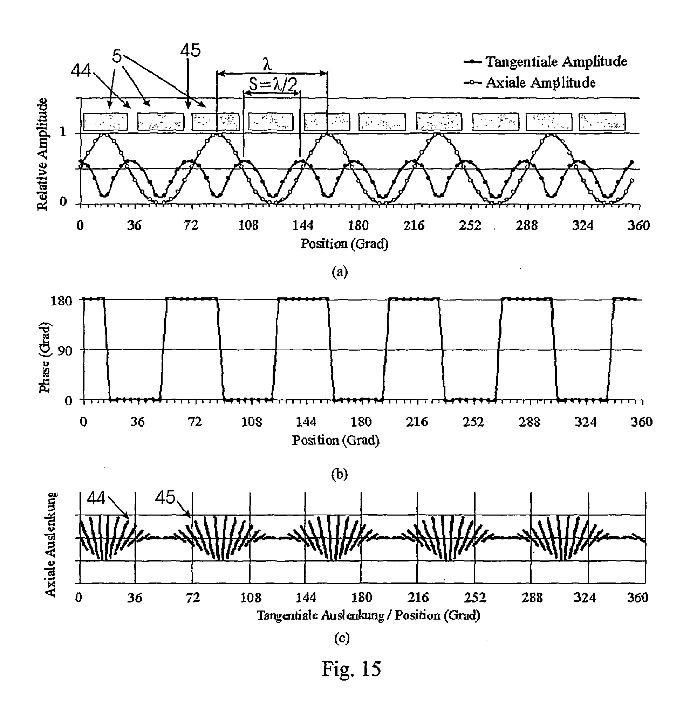

Fig. 15 stellt Bewegungsbahnen der Oszillatoroberfläche 7 bei gleichzeitiger Anregung einer stehenden Welle der gekoppelten tangential-axialen Schwingungen und der longitudinalen Schwingungen des Oszillators dar.

Bei dieser Ausführungsvariante des Oszillators 2 sind an den Oszillatoroberflächen 7 Bereiche 44 und 45 vorhanden, auf denen die tangentialen sowie axialen Schwinggeschwindigkeitskomponenten annähernd gleich sind, ihre Phasenverschiebung 0 oder 180° beträgt und die Bewegungsbahnen der Punkte unter einem Winkel zur Oberfläche 7 ausgerichtet sind.

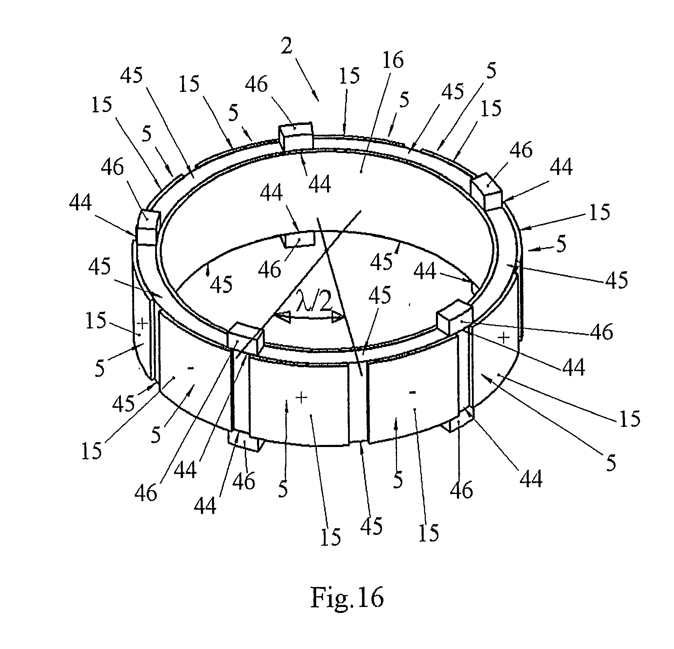

Fig. 16 zeigt einen Oszillator 2 einer einphasigen Ausführungsvariante des erfindungsgemäßen Motors unter Ausnutzung von stehenden Wellen der gekoppelten tangential-axialen Schwingungen mit fünf aktiven Generatoren 5 und fünf an seinen Oberflächen 7 in den Bereichen 44 oder 45 angeordneten Friktionselementen 46.

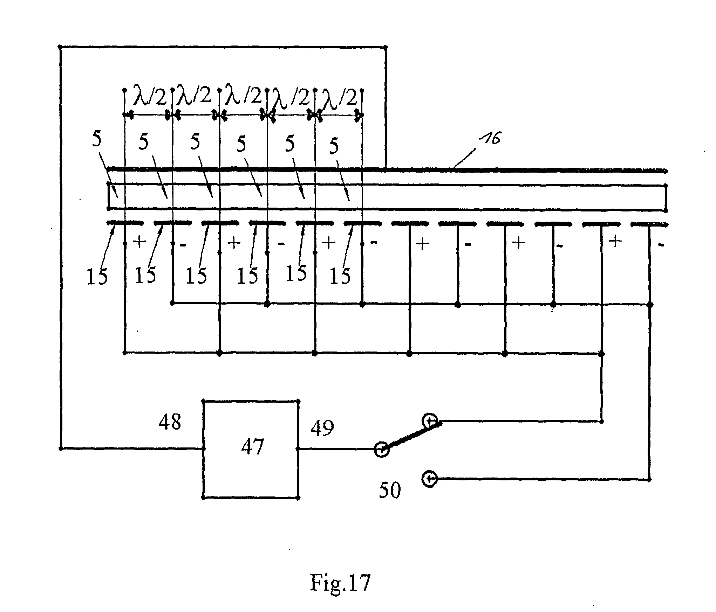

Eine entsprechende elektrische Beschaltung eines solchen einphasigen Motors nach Fig. 16 ist in Fig. 17 gezeigt. Die Anregungsquelle 47 hat einen Ausgang 48, der auf die Bezugselektrode 16 führt. Der Ausgang 49 ist über einen Umschalter 50 mit den Elektroden 15 der aktiven Generatoren verbunden. Die Quelle 47 stellt am Ausgang 49 eine einphasige elektrische Spannung bereit.

Der in der Fig. 1 gezeigter piezoelektrischer Motor besitzt folgende Funktionsweise. Beim Einschalten des Motors erzeugen die Erregerquellen 35, 39 oder 47 eine elektrische Spannung mit der Frequenz, die der Resonanzfrequenz F₀ des Oszillators 2 entspricht und bei der im Oszillator eine stehende Welle der gekoppelten tangential-axialen Schwingungsmode angeregt werden kann.

Die Resonanzfrequenz F₀ dieser Schwingungsmode des Oszillators kann annähernd nach der Beziehung F₀ = N/H bestimmt werden, wobei N eine material- und wandstärkeabhängige Frequenzkonstante ist.
Für einen Oszillator 2 mit dem Außendurchmesser von 20mm, einem Innendurchmesser von 15mm und einer Höhe von 20mm, bestehend aus einer Piezokeramik PIC 181 der Firma PI Keramik GmbH, beträgt N = 188.000 Hz • cm.

Beim Beaufschlagen der Elektroden 15, 16 des Generators 5 mit einer elektrischen Spannung wird im Oszillator 2 eine stehende Welle der gekoppelten tangential-axialen Schwingungsmode angeregt. Dadurch können, abhängig von der jeweils gewählten Frequenz, eine erste, zweite, dritte und so weiter Schwingungsmode angeregt werden, so dass auf dem Umfang des Oszillators 2 (siehe Fig. 2, 4 oder 6) sich eine, zwei, drei und so weiter Wellenlängen befinden.

Verformungsbilder eines solchen Oszillators bei der Anregung der ersten, zweiten und dritten gekoppelten tangential-axialen Schwingungsmoden zeigen die Fig. 3, 5 und 7.

Die gekoppelte tangential-axiale Schwingungsmode eines Hohlzylinders ist dadurch gekennzeichnet, dass das Schwingen des Zylinders hauptsächlich tangentiale und axiale Schwingungskomponenten aufweist, die dabei außerdem eine Phasenverschiebung von 0 oder 180° haben. Schwinggeschwindigkeits-Maxima tangentialer Schwingkomponenten befinden sich an der Oszillatorstirnseite 7 und die der axialen Komponente etwas unterhalb dieser.
Mit zunehmender Entfernung von den Oszillatorstirnseiten 7 in axialer Richtung werden beide Komponenten in ihren Werten geringer. In der Mitte der Zylinderhöhe H verläuft parallel zu den Oszillatorstirnseiten 7 eine Knotenlinie 22, auf der die axiale Schwinggeschwindigkeits-Komponente den Nullwert annimmt und die tangentiale Schwinggeschwindigkeit ein Minimum erreicht. Der Oszillatorkörper 2 wird abwechselnd durch axial verlaufende Knotenlinien 23 und 24 geteilt, in denen jeweils die tangentiale oder die axiale Schwinggeschwindigkeit den Nullwert erreicht.

Die Fig. 9 zeigt Bewegungsbahnen der auf dem Umfang des Oszillators an den Stirnoberflächen 7 liegenden Punkte bei der Anregung der gekoppelten tangential-axial Schwingungsmode im Oszillator 2. Im Oszillator 2 ist es möglich, gleichzeitig und unabhängig voneinander zwei, drei oder mehrere stehende Wellen anzuregen. Durch deren Überlagerung kann dann eine laufende Welle erzeugt werden. Zur Erzeugung einer laufenden Welle mit Hilfe von zwei stehenden Wellen ist der Oszillator 2 des vorgeschlagenen Motors mit mindestens zwei um ein Viertel der Wellenlänge räumlich verschobene Generatoren 5 (siehe Fig. 10) ausgestattet. Die Generatoren werden dann mit zwei Erregerspannungen beaufschlagt, deren Phasenverschiebung 90° beträgt.

Zur Erzeugung einer laufenden Welle mit Hilfe von drei stehenden Wellen wird der Oszillator 2 des erfindungsgemäßen Motors mit mindestens drei, um ein Drittel der Wellenlänge räumlich verschobene Generatoren 5 (siehe Fig. 12) ausgestattet. Die Generatoren werden hier mit zwei Erregerspannungen beaufschlagt, deren Phasenverschiebung 120° beträgt.

Bei beiden Fällen durchlaufen die an den Stirnseiten des Oszillators 2 liegenden Punkte die in Fig. 14 dargestellten gleichen elliptischen Bahnen. Aufgrund der elliptischen Bewegung der Stirnoberflächen-Punkte des Oszillators 2 wird dem Rotor 4 ein Drehmoment verliehen.

Bei einer weiteren vorteilhaften Variante des Motors ist der Oszillator 2 mit mindestens einer gleichnamigen Generatorgruppe 5 ausgestattet. Unter gleichnamigen Generatoren 5 wird verstanden, dass bei deren Beaufschlagung mit phasengleicher elektrischer Spannung die gleiche Oszillatorverformung hervorgerufen wird. Bei einer solchen Ausführungsvariante des Motors wird die Höhe H des Oszillators 2 so gewählt, dass im Oszillator gleichzeitig mit der gekoppelten tangential-axialen Schwingungsmode auch eine longitudinale Schwingungsmode angeregt wird. Eine gleichzeitige Anregung beider Moden ist nur dann möglich, wenn die geometrischen Abmessungen des Oszillators so gewählt werden, dass die Resonanzfrequenzen der beiden Schwingungsmoden nahe beieinander liegen.

Die Überlagerung der beiden Schwingungsmoden führt dazu, dass sich die an den Stirnoberflächen 7 des Oszillators 2 liegenden Punkte entlang gerader Linien bewegen. Der Neigungswinkel dieser Geraden zur Oberfläche wird durch die tangentialen sowie axialen Schwingamplituden im jeweiligen Oberflächenpunkt bestimmt. Fig. 15 (a) bis (c) zeigen den Verlauf tangentialer und axialer Schwinggeschwindigkeiten auf der Stirnseite des Oszillators, ihre gegenseitige Phasenlage sowie die Bewegungsbahnen der Oberflächenpunkte.
Aus der Fig. 15 ist zu erkennen, dass an den Rändern der Generatoren 5 Bereiche 44 und 45 existieren, die annähernd gleiche tangentiale und axiale Schwingungskomponente mit einem Phasenunterschied von 0 oder 180° besitzen. D. h. die Bewegungsbahnen der Punkte sind unter einem Winkel von ca. 45° zur Oberfläche 7 ausgerichtet. Bei dieser Konstruktionsvariante des Motors werden die Friktionselemente 46 an der Oberfläche 7 nur in den Bereichen 44 oder nur in den Bereichen 45 (siehe Fig. 16) angeordnet.

Durch Ansteuerung einer Gruppe der Anregungsgeneratoren wird der Stator angeregt. Der an die Sto0elemente angepresste Rotor erfährt aufgrund der von Stoßelementen erzeugten Mikrostöße eine Drehbewegung. Durch Ansteuerung einer anderen Generatorengruppe wird die Mode bzw. die stehende Welle unter den Stoßelementen um eine halbe Wellenlänge λ/*2* verschoben angeregt. Dadurch ändert sich die Phase der tangentialen Auslenkungen der Stoßelemente. Ihre Bewegungsbahnen wechseln die Richtung und der Rotor erfährt eine entgegengesetzte Drehbewegung.

Die in der Fig. 17 dargestellte Schaltungsanordnung zeigt die elektrische Verbindung der betrachteten Motorvariante. Die Schaltung ist mit dem Umschalter 50 ausgestattet, der den Ausgang 49 der Quelle 47 mit den links oder rechts von den Friktionselementen liegenden Generatoren 5 wahlweise verbindet. Hierdurch kann die Bewegungsrichtung des Rotors umgeschaltet werden.

Der zylindrische Oszillator des beschriebenen piezoelektrischen Ultraschallmotors gemäß der Erfindung hat die Maxima der tangentialen Schwinggeschwindigkeiten an seiner Stirnoberfläche und die Maxima der axialen Schwinggeschwindigkeiten etwas unterhalb dieser, also dort, wo auch der Rotor angepresst wird.

Gleichzeitig verschwinden beide Schwinggeschwindigkeiten bzw. deren Komponenten in der Mitte der Oszillatorhöhe. Dies bedeutet, dass ein derartiger Motor im Vergleich zu Dehnungswellen nutzenden Einrichtungen um den Faktor 2 geringere Verluste bezogen auf die innere Reibung aufweist. Das Entstehen eines Bereichs minimaler Schwingamplituden in der Mitte der Oszillatorhöhe ermöglicht die Anordnung einer Befestigungsvorrichtung, ohne dass dabei zusätzliche Verluste entstehen. Durch diese verlustfreie Halterung des Oszillators verbessert sich die mechanische Güte, wodurch die Erregerspannung des Motors verringert werden kann. Durch eine solche Halterung können auch ansonsten notwendig werdende elastische Einrichtungen entfallen, so dass sich die Phasencharakteristik des Motors verbessert.

### Bezugszeichenliste

- 1: Stator
- 2: Oszillator
- 3: Oszillatorstirnseiten
- 4: Rotor
- 5: Generatoren
- 6: Friktionsschicht
- 7: Stirnflächen des Oszillators
- 8: Halterung
- 9: Friktionsscheiben
- 10: elastische Elemente
- 11: Zentrierbuchsen
- 12: Welle
- 13: Lager
- 14: monolithischer piezoelektrischer Oszillator
- 15: Anregungselektrode
- 16: Bezugselektrode
- 17: Verformungsbild des Oszillators
- 18: Verteilungsdarstellung tangentialer Schwinggeschwindigkeiten
- 19: Verteilungsdarstellung axialer Schwinggeschwindigkeiten
- 20: Maximum tangentialer Schwinggeschwindigkeiten
- 21: Minimum tangentialer Schwinggeschwindigkeiten
- 22: Knotenlinie
- 23: Null-Linien tangentialer Schwinggeschwindigkeiten
- 24: Null-Linien axialer Schwinggeschwindigkeiten
- 25: Verformungsbild des Oszillators
- 26: Verteilungsdarstellung tangentialer Schwinggeschwindigkeiten
- 27: Verteilungsdarstellung axialer Schwinggeschwindigkeiten
- 28: Verformungsbild des Oszillators
- 29: Verteilungsdarstellung tangentialer Schwinggeschwindigkeiten
- 30: Verteilungsdarstellung axialer Schwinggeschwindigkeiten
- 31: nicht piezoelektrischer Körper des Oszillators
- 32: Piezoelement
- 33: piezoelektrische Platten
- 34: Elektrode am Piezoelement
- 35: zweiphasige Erregerquelle des Oszillators
- 36 bis 38: Ausgänge der Quelle 35
- 39: dreiphasige Erregerquelle des Oszillators
- 40 bis 43: Ausgänge der Quelle 39
- 44 bis 45: Bereiche der Oberfläche 7
- 46: Friktionselemente
- 47: einphasige Erregerquelle des Oszillators
- 48 bis 49: Ausgänge der Quelle 47
- 50: Umschalter

## Patentansprüche

1. Verfahren zum Betreiben eines piezoelektrischen Motors mit einem Stator in Form eines hohlzylindrischen Oszillators, dessen mindestens eine Stirnseite mit einem Rotor in Friktionskontakt steht sowie Stehwellengeneratoren umfassend, wobei
der Hohlzylinder in eine gekoppelte tangential-axiale Schwingungsmode versetzt wird, **dadurch gekennzeichnet, dass** die tangentialen und axialen Schwinggeschwindigkeitskomponenten der dabei im Oszillator entstehenden Stehwelle bzw. die Punkte des Zylinders die gleiche Phase haben oder einen Phasenunterschied von 180° aufweisen, sich die Schwinggeschwindigkeits-Maxima der tangentialen Komponente an den Stirnseiten des Hohlzylinders und diejenigen der axialen Komponente darunter ausbilden, wobei zur Mitte der Zylinderhöhe, parallel zu den Stirnseiten des Zylinders, eine Knotenlinie vorhanden ist, auf der die axiale Schwinggeschwindigkeitskomponente den Wert Null sowie die tangentiale Komponente ein Minimum annimmt und weiterhin im Hohlzylinderkörper je nach der Modenordnung axial verlaufende Knotenlinien resultieren, auf denen die axialen oder tangentialen Schwinggeschwindigkeitskomponenten Nullwerte annehmen.

2. Verfahren nach Anspruch 1,
**dadurch gekennzeichnet, dass**
die Stehwellengeneratoren mit einer Frequenz angeregt werden, die der OszillatorResonanzfrequenz entspricht und bei der sich eine stehende Welle der gekoppelten tangential-axialen Schwingungsmode ausbildet.

3. Piezoelektrischer Motor mit einem Stator in Form eines hohlzylindrischen Oszillators, dessen mindestens eine Stirnseite mit einem Rotor in Friktionskontakt steht und welcher Stehwellengeneratoren aufweist, die so ausgebildet sind, dass sie
gekoppelte tangential-axiale Schwingungen im hohlzylindrischen Oszillator erzeugen, **dadurch gekennzeichnet, dass** beide Komponenten dieselbe Phasenlage haben oder einen 180° Phasenunterschied aufweisen, die tangentialen Schwinggeschwindigkeits-Maxima auf den Stirnseiten und die axialen Schwinggeschwindigkeits-Maxima unterhalb dieser liegen sowie beide Schwinggeschwindigkeitskomponenten zur halben Höhe des Hohlzylinders abnehmen, so daß die kinetische Antriebsenergie für den Rotor in der Nähe der Hohlzylinder-Stirnseiten konzentriert ist, sowie weiterhin im mittleren Teil auf der Null-Linie der Werte der Komponenten eine mechanische Befestigung für den Motor angeordnet oder vorgesehen ist.

4. Piezoelektrischer Motor nach Anspruch 3,
**dadurch gekennzeichnet, dass**
der hohlzylindrische Oszillator ein monolithischer piezoelektrischer Körper ist, auf dessen einer Mantelfläche sich eine oder mehrere Elektroden und dessen anderer Mantelfläche eine gemeinsame Bezugselektrode befindet, welche zusammen mit der dazwischen liegenden Piezokeramik Generatoren stehender Wellen bilden.

5. Piezoelektrischer Motor nach Anspruch 3,
**dadurch gekennzeichnet, dass**
der hohlzylindrische Oszillator ein monolithischer, nicht piezoelektrischer Körper ist, wobei die Generatoren als starr mit dem Hohlzylinder verbundene Piezoelemente mit entsprechenden Elektroden ausgeführt sind.

6. Piezoelektrischer Motor nach einem der Ansprüche 3 bis 5,
**dadurch gekennzeichnet, dass**
der Oszillator so ausgebildet ist, dass er zwei, räumlich um ein Viertel der Wellenlänge verschobene Stehwellengeneratoren aufweist, deren elektrische Anregung beim Betrieb eine Phasenverschiebung von 90° besitzt, wodurch im Oszillator eine laufende Welle erzeugt wird und der Rotor eine der laufenden Welle entgegengesetzte Bewegungsrichtung aufweist.

7. Piezoelektrischer Motor nach einem der Ansprüche 3 bis 5,
**dadurch gekennzeichnet, dass**
der Oszillator so ausgebildet ist, dass er drei, räumlich um ein Drittel der Wellenlänge verschobene Stehwellengeneratoren enthält, deren elektrische Anregung beim Betrieb eine Phasenverschiebung von 120° besitzt, wodurch im Oszillator eine laufende Welle erzeugt wird und der Rotor eine der laufenden Welle entgegengesetzte Bewegungsrichtung aufweist.

8. Piezoelektrischer Motor nach Anspruch 3,
**dadurch gekennzeichnet, dass**
der Oszillator so ausgebildet ist, dass er mindestens eine Gruppe gleichnamiger Generatoren akustischer Stehwellen enthält, die gegeneinander um eine halbe Wellenlänge verschoben und mit einer elektrischen Erregerquelle verbunden sind, wobei die Oszillatorhöhe so gewählt ist, dass beim Betrieb gleichzeitig mit dem tangential-axialen Mode ein Longitudinalmode angeregt wird, wobei die Überlagerung beider Moden die an den Stirnseiten des Hohlzylinders liegenden Punkte zur Ausführung elliptischer oder geradliniger Bewegungen veranlasst.

9. Piezoelektrischer Motor nach einem der Ansprüche 3 bis 8,
**dadurch gekennzeichnet, dass**
der hohlzylindrische Oszillatorkörper an seinen Stirninnenseiten eine Konusform zur selbstzentrierenden Führung und Lagerung des Rotors aufweist, welcher an seinen jeweiligen Enden einen gegenkonusförmigen Abschnitt umfasst.

10. Piezoelektrischer Motor nach Anspruch 3 bis 8,
**dadurch gekennzeichnet, dass**
die Stehwellengeneratoren beim Betrieb mit einer Frequenz angeregt werden, die der Oszillatorresonanzfrequenz entspricht und bei der sich eine stehende Welle der gekoppelten tangential-axialen Schwingungsmode ausbildet.

11. Piezoelektrischer Motor nach einem der Ansprüche 3 bis 8,
**dadurch gekennzeichnet, dass**
im mittleren Teil des Hohlzylinders auf der parallel zu den Stirnseiten verlaufenden Knotenlinie eine mechanische Befestigung für den Stator angeordnet oder vorgesehen ist.

## Claims

1. Method for operating a piezoelectric motor having a stator in the form of a hollow-cylindrical oscillator, the at least one front side of which has frictional contact with a rotor and comprising standing wave generators, wherein the hollow cylinder is set into a coupled tangential-axial oscillation mode,
**characterized in that**
the tangential and axial oscillatory speed components of the standing wave thus formed in the oscillator or, respectively, the points of the cylinder have the same phase or a phase difference of 180°, that the oscillatory speed maximums of the tangential component are formed on the front sides of the hollow cylinder and those of the axial component underneath thereof, wherein, towards the center of the cylinder height, parallel to the front sides of the cylinder, a nodal line is formed on which the axial oscillatory speed component adopts the value zero and the tangential component adopts a minimum, and wherein further axially extending nodal lines are formed in the hollow-cylindrical body in dependence on the mode order on which the axial or tangential oscillatory speed components adopt zero values.

2. Method according to claim 1,
**characterized in that**
the standing wave generators are excited with a frequency which corresponds to the oscillator resonance frequency and at which a standing wave of the coupled tangential-axial oscillation mode is formed.

3. Piezoelectric motor having a stator in the form of a hollow-cylindrical oscillator, the at least one front side of which has frictional contact with a rotor and which comprises standing wave generators adapted to generate coupled tangential-axial oscillations in the hollow-cylindrical oscillator,
**characterized in that**
both components have the same phase position or a phase difference of 180°, the tangential oscillatory speed maximums are located on the front sides and the axial oscillatory speed maximums underneath the same and both oscillatory speed components decrease towards half the height of the hollow cylinder so that the kinetic drive energy for the rotor is concentrated in the proximity of the front sides of the hollow cylinder, and that further a mechanical attachment for the motor is arranged or provided in the central portion on the zero line of the values of the components.

4. Piezoelectric motor according to claim 3,
**characterized in that**
the hollow-cylindrical oscillator is a monolithic piezoelectric body on the one surface area of which one or more electrodes are provided and on the other surface area of which a common reference electrode is provided, both forming generators of standing waves together with the piezoelectric ceramic disposed therebetween.

5. Piezoelectric motor according to claim 3,
**characterized in that**
the hollow-cylindrical oscillator is a monolithic non-piezoelectric body, wherein the generators are constructed as piezoelectric elements rigidly connected to the hollow cylinder with corresponding electrodes.

6. Piezoelectric motor according to one of claims 3 to 5,
**characterized in that**
the oscillator is adapted to comprise two standing wave generators spatially displaced by one fourth of the wavelength, the electrical excitation of which has in operation a phase quadrature by which a traveling wave is generated in the oscillator and the rotor has a moving direction opposite to the traveling wave.

7. Piezoelectric motor according to one of claims 3 to 5,
**characterized in that**
the oscillator is adapted to comprise three standing wave generators spatially displaced by one third of the wavelength, the electrical excitation of which has in operation a phase displacement by 120° by which a traveling wave is generated in the oscillator and the rotor has a moving direction opposite to the traveling wave.

8. Piezoelectric motor according to claim 3,
**characterized in that**
the oscillator is adapted to comprise at least one group of like generators of acoustic standing waves displaced against each other by half a wavelength and connected to an electrical exciting source, wherein the oscillator height is selected such that in operation a longitudinal mode is excited simultaneously with the tangential-axial mode, wherein the superposition of both modes causes the points located on the front sides of the hollow cylinder to perform elliptical or straight movements.

9. Piezoelectric motor according to one of claims 3 to 8,
**characterized in that**
the hollow-cylindrical oscillator body has a conical shape on the front insides thereof so as to guide and mount the rotor in a self-centering manner, which has a counter-conically shaped section at its respective ends.

10. Piezoelectric motor according to one of claims 3 to 8,
**characterized in that**
in operation the standing wave generators are excited with a frequency which corresponds to the oscillator resonance frequency and at which a standing wave of the coupled tangential-axial oscillation mode is formed.

11. Piezoelectric motor according to one of claims 3 to 8,
**characterized in that**
a mechanical attachment for the stator is arranged or provided in the central portion of the hollow cylinder on the nodal line extending parallel to the front sides.

## Revendications

1. Procédé pour faire fonctionner un moteur piézoélectrique qui comprend un stator sous la forme d'un oscillateur cylindrique creux, dont au moins une face frontale est en contact de friction avec un rotor, et des générateurs d'ondes stationnaires, dans lequel le cylindre creux est mis dans un mode d'oscillation couplé tangentiel/axial,
**caractérisé en ce que** les composantes tangentielle et axiale de la vitesse d'oscillation de l'onde stationnaire générée ici dans l'oscillateur, ou respectivement les points du cylindre, ont la même phase ou présentent une différence de phase de 180°, les maxima de la composante tangentielle de la vitesse d'oscillation se forment au niveau des faces frontales du cylindre creux et les maxima de la composante axiale de la vitesse d'oscillation se forment au-dessous de celles-ci, de sorte que, vers le milieu de la hauteur du cylindre et parallèlement aux faces frontales du cylindre, se présente une ligne de noeuds sur laquelle la composante axiale de vitesse d'oscillation prend la valeur zéro et la composante tangentielle prend une valeur minimum, et en outre, il en résulte dans le corps cylindrique creux et selon l'ordre du mode, des lignes de noeuds qui s'étendent axialement et sur lesquelles la composante axiale ou la composante tangentielle de la vitesse d'oscillation prennent la valeur zéro.

2. Procédé selon la revendication 1,
**caractérisé en ce que** les générateurs d'ondes stationnaires sont excités à une fréquence qui correspond à la fréquence de résonance de l'oscillateur et à laquelle se forme une onde stationnaire du mode d'oscillation couplé tangentiel/axial.

3. Moteur piézoélectrique comprenant un stator sous la forme d'un oscillateur cylindrique creux, dont au moins une face frontale est en contact de friction avec un rotor, et comprenant des générateurs d'ondes stationnaires réalisés de telle manière qu'ils engendrent des oscillations couplées tangeritielles/axiales dans l'oscillateur cylindrique creux,
**caractérisé en ce que** les deux composantes ont la même position en phase ou présentent une différence de phase de 180°, les maxima de la vitesse d'oscillation tangentielle étant situés sur les faces frontales et les maxima de la vitesse d'oscillation axiale étant situés au-dessous de celles-ci, et les deux composantes de vitesse d'oscillation diminuent vers la moitié de la hauteur du cylindre creux, de sorte que l'énergie d'entraînement cinétique pour le rotor est concentrée au voisinage des faces frontales du cylindre creux, et dans lequel une fixation mécanique pour le moteur est agencée ou prévue en outre dans la partie médiane sur la ligne où les composantes prennent la valeur zéro.

4. Moteur piézoélectrique selon la revendication 3,
**caractérisé en ce que** l'oscillateur cylindrique creux est un corps piézoélectrique monolithique avec une surface enveloppe sur laquelle se trouvent une ou plusieurs électrodes et avec une autre surface enveloppe sur laquelle se trouvent une électrode de référence commune, lesquels forment des générateurs d'ondes stationnaires conjointement avec la piézocéramique située entre elles.

5. Moteur piézoélectrique selon la revendication 3,
**caractérisé en ce que** l'oscillateur cylindrique creux est un corps monolithique non piézoélectrique, et les générateurs sont réalisés sous forme d'éléments piézoélectriques reliés rigidement au cylindre creux et présentant des électrodes correspondantes.

6. Moteur piézoélectrique selon l'une des revendications 3 à 5,
**caractérisé en ce que** l'oscillateur est ainsi réalisé qu'il comprend deux générateurs d'ondes stationnaires décalés dans l'espace d'un quart de la longueur d'onde, dont l'excitation électrique en service possède un décalage de phase de 90°, grâce à quoi une onde permanente est générée dans l'oscillateur et le rotor présente une direction de déplacement opposée à l'onde permanente.

7. Moteur piézoélectrique selon l'une des revendications 3 à 5,
**caractérisé en ce que** l'oscillateur et ainsi réalisé qu'il contient trois générateurs d'ondes stationnaires décalés dans l'espace d'un tiers de la longueur d'onde, dont l'excitation électrique en service possède un décalage de phase de 120°, grâce à quoi une onde permanente est générée dans l'oscillateur et le rotor présente une direction de déplacement opposée à l'onde permanente.

8. Moteur piézoélectrique selon la revendication 3,
**caractérisé en ce que** l'oscillateur est ainsi réalisé qu'il contient au moins un groupe de générateurs d'ondes acoustiques de même type, qui sont décalés l'un par rapport à l'autre d'une moitié de la longueur d'onde et qui sont reliés à une source d'excitation électrique, la hauteur de l'oscillateur étant ainsi choisie que, en fonctionnement, un mode longitudinal est excité simultanément avec le mode tangentiel/axial, et la superposition des deux modes amène les points situés sur les faces frontales du cylindre creux à exécuter des mouvements elliptiques ou rectilignes.

9. Moteur piézoélectrique selon l'une des revendications 3 à 8,
**caractérisé en ce que** le corps de l'oscillateur cylindrique creux présente au niveau de ses côtés intérieurs frontaux une forme conique pour le guidage autocentré et pour le montage du rotor, lequel présente à ses extrémités respectives un tronçon de forme conique complémentaire.

10. Moteur piézoélectrique selon l'une des revendications 3 à 8,
**caractérisé en ce que** les générateurs d'ondes stationnaires sont excités en service à une fréquence qui correspond à la fréquence de résonance de l'oscillateur et à laquelle se forme une onde stationnaire du mode d'oscillation couplé tangentiel/axial.

11. Moteur piézoélectrique selon l'une des revendications 3 à 8,
**caractérisé en ce qu'**une fixation mécanique pour le stator est agencée ou prévue dans la partie médiane du cylindre creux sur la ligne de noeuds qui s'étend parallèlement aux faces frontales.
